# EUROPEAN PATENT SPECIFICATION

(11) **EP 3 297 033 B1**
(45) Date of publication and mention of the grant of the patent: **08.01.2025**
(21) Application number: 17191154.8
(22) Date of filing: 14.09.2017
(51) Int. Cl.: H01L 31/05, H01L 31/0352, H01L 31/041, H01L 31/042, H01L 31/044, H01L 31/0687

(54) **REWORK AND REPAIR OF COMPONENTS IN A SOLAR CELL ARRAY**
NACHBEARBEITUNG UND REPARATUR VON KOMPONENTEN IN EINER SOLARZELLENANORDNUNG
RECYCLAGE ET RÉPARATION DE COMPOSANTS DANS UN RÉSEAU DE PILES SOLAIRES

(30) Priority: 14.09.2016 US 201662394632 P; 14.09.2016 US 201662394636 P; 14.09.2016 US 201662394616 P; 14.09.2016 US 201662394623 P; 14.09.2016 US 201662394627 P; 14.09.2016 US 201662394629 P; 14.09.2016 US 201662394649 P; 14.09.2016 US 201662394666 P; 14.09.2016 US 201662394667 P; 14.09.2016 US 201662394671 P; 14.09.2016 US 201662394641 P; 14.09.2016 US 201662394672 P; 06.07.2017 US 201715643279; 06.07.2017 US 201715643274; 06.07.2017 US 201715643277; 06.07.2017 US 201715643282; 06.07.2017 US 201715643285; 06.07.2017 US 201715643287; 06.07.2017 US 201715643289
(43) Date of publication of application: 21.03.2018
(60) Divisional application: 23178386.1
(73) Proprietor: The Boeing Company, Arlington, VA 22202 (US)
(72) Inventor: REHDER, Eric, Chicago, 60606-1596 (US)
(74) Representative: Witte, Weller & Partner Patentanwälte mbB

(56) References cited:
- EP-A2- 1 548 847
- US-A- 5 567 248
- US-A1- 2015 144 173

## Description

### BACKGROUND INFORMATION

### 1. Field.

The disclosure is related generally to solar cell panels and, more specifically, to rework and repair of components in a solar cell array.

### 2. Background.

Typical spaceflight-capable solar cell panel assembly involves building long strings of solar cells. These strings are variable in length and can be very long, for example, up to and greater than 20 cells. Assembling such long, variable, and fragile materials is difficult, which has prevented automation of the assembly.

Existing solutions use solar cells assembled into CIC (cell, interconnect and coverglass) units. The CIC has metal foil interconnects connected to the front of the cell that extend in parallel from one side of the CIC. The CICs are located close to each other and the interconnects make connection to the bottom of an adjacent cell. Using these interconnects, the CICs are assembled into linear strings. These linear strings are built-up manually and then laid out to form a large solar cell array comprised of many strings of variable length.

Additionally, a bypass diode is used to protect the cells from reverse bias, when the cells become partially shadowed. The bypass diode generally connects the back contacts of two adjacent cells within the solar cell array.

When used in a satellite, the solar cell array is typically packaged as a panel. The dimensions of the panel are dictated by the needs of the satellite, including such constraints as needed power, as well as the size and shape necessary to pack and store the satellite in a launch vehicle. Furthermore, the deployment of the panel often requires that some portions of the panel are used for the mechanical fixtures and the solar cell array must avoid these locations. In practice, the panel is generally rectangular, but its dimensions and aspect ratio vary greatly. The layout of the CICs and strings to fill this space must be highly customized for maximum power generation, which results in a solar panel fabrication process that is highly manual.

EP 1 548 847 A2 discloses a solar generator panel and corresponding satellite.

What is needed, then, is a means for promoting automated manufacturing of solar arrays, while preserving the ability for customization of solar cell arrays.

The present application relates to a substrate for a solar cell panel, according to claim 1, and to a method of repairing a substrate on which solar cells are attached, according to claim 6. Optional features are further specified in the dependent claims.

### DRAWINGS

Referring now to the drawings in which like reference numbers represent corresponding parts throughout:
FIGS. 1 and 2 illustrate conventional structures for solar cell panels.
FIGS. 3A and 3B illustrate an improved structure for a solar cell panel, according to one example.
FIGS. 4A and 4B illustrate an alternative structure for the solar cell panel, according to one example.
FIG. 5 illustrates the front side of an exemplary solar cell that may be used in the improved solar cell panel of FIGS. 3A-3B and 4A-3B.
FIG. 6 illustrates the back side of the exemplary solar cell of FIG. 5.
FIG. 7 illustrates cells arranged into the 2D grid of the array, according to one example.
FIG. 8 illustrates an example of the array where one or more bypass diodes are added to the exposed area of the substrate in the corner regions.
FIG. 9 illustrates an example where the bypass diode is applied to the back side of the cell, with an interconnect or contact for the bypass diode extending into the corner region between front and back contacts.
FIG. 10 illustrates a front side view of the example of FIG. 9, with the interconnect or contact for the bypass diode extending into the corner region between the front and back contacts.
FIG. 11 illustrates the cells of FIGS. 9 and 10 arranged into the 2D grid of the array and applied to the substrate, where the bypass diodes are applied to the back side of the cells, with the contacts for the bypass diodes extending into the corner regions of the cells.
FIG. 12 shows up/down series connections between the cells of the array, according to one example.
FIG. 13 shows left/right series connections between the cells of the array, according to one example.
FIG. 14 illustrates a connection scheme between a plurality of solar cells of an array, according to one example.
FIG. 15 shows a side view of an example wherein the substrate is a flex sheet assembly, according to one example.
FIG. 16 illustrates an example where a metal foil interconnect from a solar cell has separated from a connection pad, according to one example.
FIG. 17 shows one proposed repair process for the example of FIG. 16, wherein an area of the connection pad is large enough that a second connection can be made by a metal foil interconnect, according to one example.
FIG. 18 shows how the repair components are used, in one example.
FIG. 19 describes a method of fabricating a solar cell, solar cell panel and/or satellite, according to one example.
FIG. 20 illustrates a resulting satellite having a solar cell panel comprised of solar cells, according to one example.
FIG. 21 is an illustration of the solar cell panel in the form of a functional block diagram, according to one example.

### DETAILED DESCRIPTION

In the following description, reference is made to the accompanying drawings which form a part hereof, and in which is shown by way of illustration a specific example in which the disclosure may be practiced. It is to be understood that other examples may be utilized and structural changes may be made without departing from the scope of the present disclosure.

### GENERAL DESCRIPTION

A new approach to the design of solar cell arrays, such as those used for spaceflight power applications, is based on electrical connections among the solar cells in the array.

This new approach rearranges the components of a solar cell and the arrangements of the solar cells in the array. Instead of having solar cells connected into long linear strings and then assembled onto a substrate, the solar cells are attached individually to a substrate, such that comer regions of adjacent cells are aligned on the substrate, thereby exposing an area of the substrate. Electrical connections between cells are made by comer conductors formed on or in the substrate in these corner regions. Consequently, this approach presents a solar cell array design based on individual cells.

Thus, a single laydown process and layout can be used in the fabrication of solar cell arrays. Current flow between solar cells will be assisted with conductors embedded in the substrate. These electrical connections define the specific characteristics of the solar cell array, such as its dimensions, stayout zones, and circuit terminations. This approach simplifies manufacturing, enables automation, and reduces costs and delivery times.

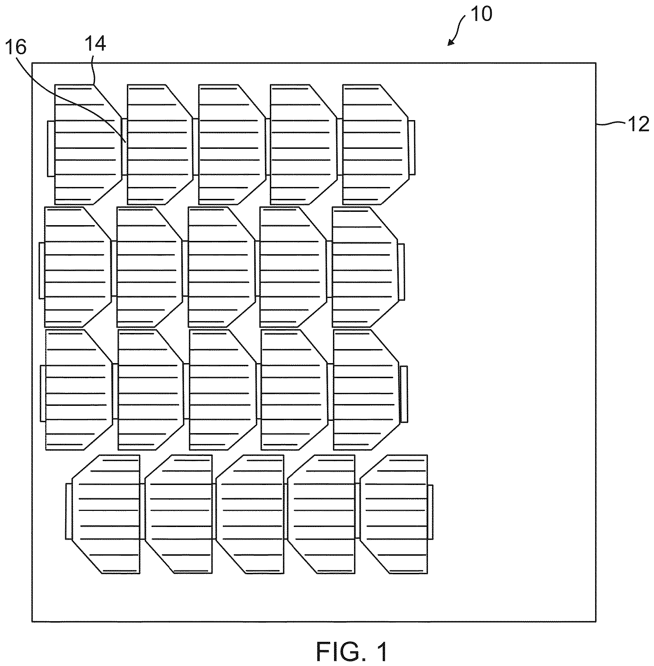

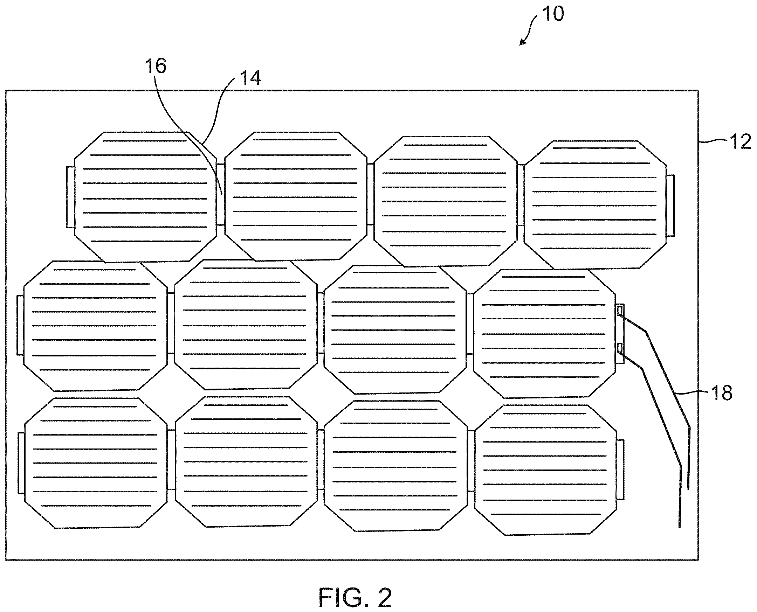

FIGS. 1 and 2 illustrate conventional structures for solar cell panels 10, which include a substrate 12, a plurality of solar cells 14 arranged in an array, and electrical connectors 16 between the solar cells 14. Half size solar cells 14 are shown in FIG. 1 and full size solar cells 14 are shown in FIG. 2. Space solar cells 14 are derived from a round Germanium (Ge) substrate starting material, which is later fabricated into semi-rectangular shapes to improve dense packing onto the solar cell panel 10. This wafer is often diced into one or two solar cells 14 herein described as half size or full size solar cells 14. The electrical connectors 16 providing electrical connections between solar cells 14 are made along the long parallel edge between solar cells 14. These series connections (cell-to-cell) are completed off-substrate, as strings of connected solar cells 14 are built having lengths of any number of solar cells 14. The completed strings of solar cells 14 are then applied and attached to the substrate 12.

In FIG. 2, wiring 18 is attached at the end of a string of solar cells 14 to electrically connect the string to other strings, or to terminate the resulting circuit and bring the current off of the array of solar cells 14. String-to-string and circuit termination connections are typically done on the substrate 12, and typically using wiring 18. However, some solar cell panels 10 use a printed circuit board (PCB)-type material with embedded conductors.

Adjacent strings of connected solar cells 14 can run parallel or anti-parallel. In addition, strings of connected solar cells 14 can be aligned or misaligned. There are many competing influences to the solar cell 14 layout resulting in regions where solar cells 14 are parallel or anti-parallel, aligned or misaligned.

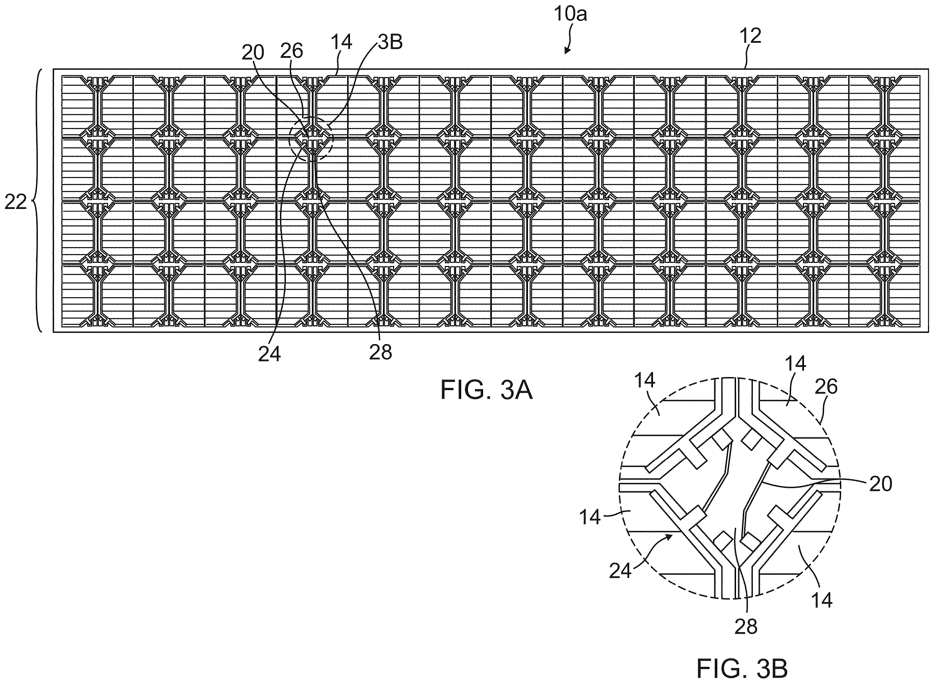

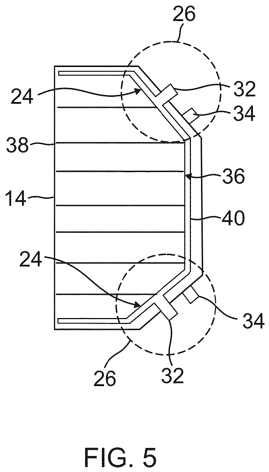

FIGS. 3A and 3B illustrate improved devices and structures for a solar cell panel 10a, according to one example, wherein FIG. 3B is an enlarged view of the details in the dashed circle in FIG. 3A. The various components of the solar cell panel 10a are shown and described in greater detail in FIGS. 5-13.

The solar cell panel 10a includes a substrate 12 for solar cells 14 having one or more corner conductors 20 thereon. In one example, the substrate 12 is a multi-layer substrate 12 comprised of one or more Kapton^{®} (polyimide) layers separating one or more patterned metal layers. The substrate 12 may be mounted on a large rigid panel 10a similar to conventional assembles. Alternatively, the substrate 12 can be mounted to a lighter more sparse frame or panel 10a for mounting or deployment.

A plurality of solar cells 14 are attached to the substrate 12 in a two-dimensional (2-D) grid of an array 22. In this example, the array 22 is comprised of ninety-six (96) solar cells 14 arranged in four (4) rows by twenty-four (24) columns, but it is recognized that any number of solar cells 14 may be used in different implementations.

The solar cells 14 have cropped corners 24 that define corner regions 26, as indicated by the dashed circle. The solar cells 14 are attached to the substrate 12, such that comer regions 26 of adjacent ones of the solar cells 14 are aligned, thereby exposing an area 28 of the substrate 12. The area 28 of the substrate 12 that is exposed includes one or more of the corner conductors 20, and one or more electrical connections between the solar cells 14 and the corner conductors 20 are made in the corner regions 26 resulting from the cropped corners 24 of the solar cells 14.

In this example, the corner conductors 20 are conductive paths attached to, printed on, buried in, or deposited on the substrate 12, before and/or after the solar cells 14 are attached to the substrate 12, which facilitate connections between adjacent solar cells 14. The connections between the solar cells 14 and the corner conductors 20 are made after the solar cells 14 have been attached to the substrate 12.

In one example, four adjacent solar cells 14 are aligned on the substrate 12, such that four cropped corners 24, one from each solar cell 14, are brought together at the corner regions 26. The solar cells 14 are then individually attached to the substrate 12, wherein the solar cells 14 are placed on top of the corner conductors 20 to make the electrical connection between the solar cells 14 and the corner conductors 20.

The solar cells 14 may be applied to the substrate 12 as CIC (cell, interconnect and coverglass) units. Alternatively, bare solar cells 14 may be assembled on the substrate 12, and then interconnects applied to the solar cells 14, followed by the application of a single solar cell 14 coverglass, multiple solar cell 14 coverglass, multiple cell polymer coversheet, or spray encapsulation. This assembly protects the solar cells 14 from damage that would limit performance.

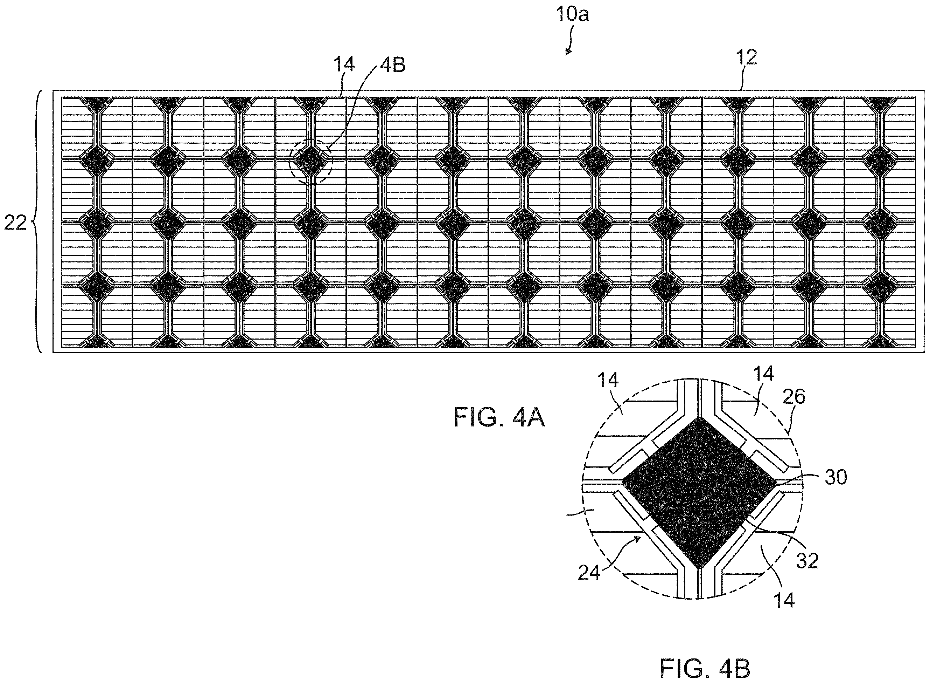

FIGS. 4A and 4B illustrate an alternative structure for the solar cell panel 10a, according to one example, wherein FIG. 4B is an enlarged view of the details in the dashed circle in FIG. 4A. In this example, only a few corner conductors 20 are printed on or integrated with the substrate 12. Instead, most of the corner conductors 20 are contained within a power routing module (PRM) 30 that is attached to the substrate 12.

FIG. 5 illustrates the front side of an exemplary solar cell 14 that may be used in the improved solar cell panel 10a of FIGS. 3A-3B and 4A-4B. The solar cell 14, which is a CIC unit, is a half-size solar cell 14. (Full-size solar cells 14 could also be used.)

The solar cell 14 is fabricated having at least one cropped corner 24 that defines a corner region 26, as indicated by the dashed circle, such that the corner region 26 resulting from the cropped corner 24 includes at least one contact 32, 34 for making an electrical connection to the solar cell 14. In the example of FIG. 5, the solar cell 14 has two cropped corners 24, each of which has both a front contact 32 on the front side of the solar cell 14 and a back contact 34 on a back side of the solar cell 14, where the contacts 32 and 34 extend into the corner region 26. (Full-size solar cells 14 would have four cropped corners 24, each of which would have a front contact 32 and a back contact 34.)

The cropped corners 24 increase utilization of the round wafer starting materials for the solar cells 14. In conventional panels 10, these cropped corners 24 would result in unused space on the panel 10 after the solar cells 14 are attached to the substrate 12. The new approach described in this disclosure, however, utilizes this unused space. Specifically, metal foil interconnects, comprising the corner conductors 20, front contacts 32 and back contacts 34, are moved to the corner regions 26. In contrast, existing CICs have interconnects attached to the solar cell 14 front side, and connect to the back side (where connections occur) during stringing.

The current generated by the solar cell 14 is collected on the front side of the solar cell 14 by a grid 36 of thin metal fingers 38 and wider metal bus bars 40 that are connected to both of the front contacts 32. There is a balance between the addition of metal in grid 36, which reduces the light entering the solar cell 14 and its output power, and the reduced resistance of having more metal. The bus bar 40 is a low resistance conductor that carries high currents and also provides redundancy should a front contact 32 become disconnected. Optimization generally desires a short bus bar 40 running directly between the front contacts 32. Having the front contact 32 in the cropped corner 24 results in moving the bus bar 40 away from the perimeter of the solar cell 14. This is achieved while simultaneously minimizing the bus bar 40 length and light obscuration. Additionally, the fingers 38 are now shorter. This reduces parasitic resistances in the grid 36, because the length of the fingers 38 is shorter and the total current carried is less. This produces a design preference where the front contacts 32 and connecting bus bar 40 is moved to provide shorter narrow fingers 38.

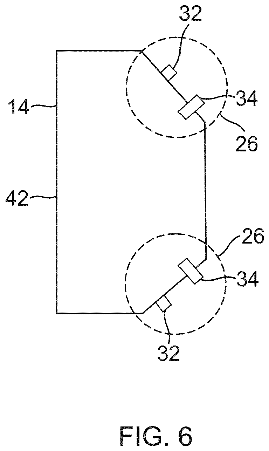

FIG. 6 illustrates the back side of the exemplary solar cell 14 of FIG. 5. The back side of the solar cell 14 has a metal back layer 42 that is connected to both of the back contacts 34.

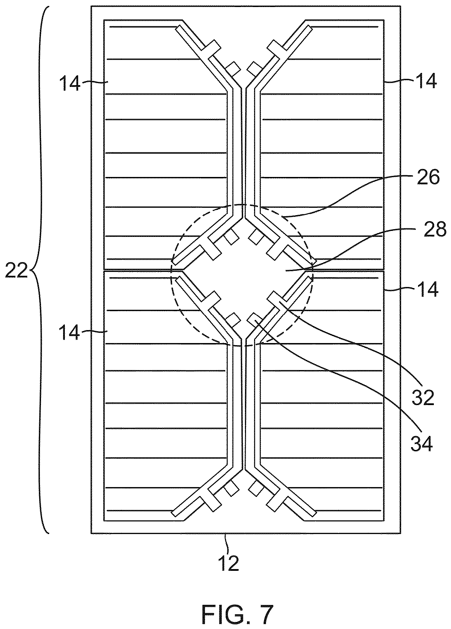

FIG. 7 illustrates solar cells 14 arranged into the 2D grid of the array 22, according to one example. The array 22 comprises a plurality of solar cells 14 attached to a substrate 12, such that comer regions 26 of adjacent ones of the solar cells 14 are aligned, thereby exposing an area 28 of the substrate 12. Electrical connections (not shown) between the solar cells 14 are made in the exposed area 28 of the substrate 12 using the front contacts 32 and back contacts 34 of the solar cells 14 and comer conductors 20 (not shown) formed on or in the exposed area 28 of the substrate 12.

During assembly, the solar cells 14 are individually attached to the substrate 12. This assembly can be done directly on a support surface, i.e., the substrate 12, which can be either rigid or flexible. Alternatively, the solar cells 14 could be assembled into the 2D grid of the array 22 on a temporary support surface and then transferred to a final support surface, i.e., the substrate 12.

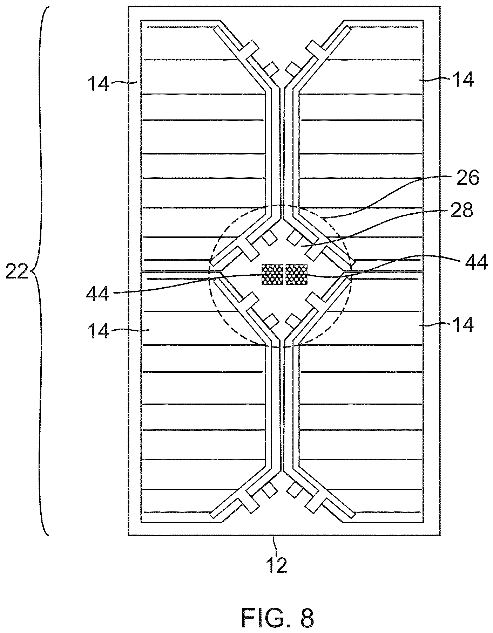

FIG. 8 illustrates an example of the array 22 where one or more bypass diodes 44 are added to the exposed area 28 of the substrate 12 in the corner regions 26, for use in one or more of the electrical connections. The bypass diodes 44 protect the solar cells 14 when the solar cells 14 become unable to generate current, which could be due to being partially shadowed, which drives the solar cells 14 into reverse bias. In one example, the bypass diodes 44 are attached to the substrate 12 in the corner regions 26 independent of the solar cells 14.

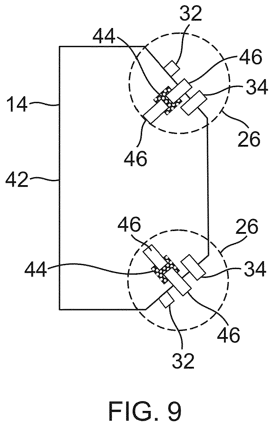

FIG. 9 illustrates an example where the bypass diode 44 is applied to the back side of the solar cell 14, with interconnects or contacts 46 for the bypass diode 44 connected to the back layer 42 and also extending into the corner region 26 between the front and back contacts 32, 34.

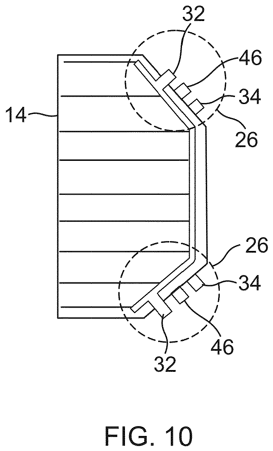

FIG. 10 illustrates a front side view of the example of FIG. 9, with the interconnect or contact 46 for the bypass diode 44 (not shown) extending into the corner region 26 between the front and back contacts 32, 34.

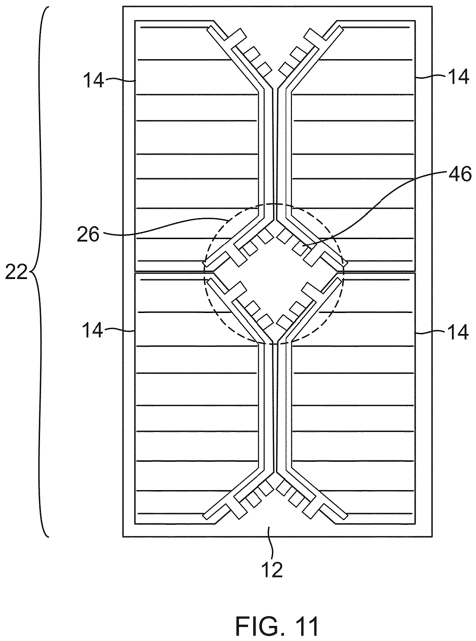

FIG. 11 illustrates the solar cells 14 of FIGS. 9 and 10 arranged into the 2D grid of the array 22 and applied to the substrate 12, where the bypass diodes 44 (not shown) are applied to the back side of the solar cells 14, with the contacts 46 for the bypass diodes 44 extending into the corner regions 26 of the solar cells 14.

One advantage of this approach is that the layouts illustrated in FIGS. 7, 8 and 11 are generalized layouts. Specifically, these layouts can be repeated across any panel 10a dimensions desired by a customer. This greatly simplifies assembly, rework, test, and inspection processes.

The placement of the solar cell 14 and bypass diode 44 is generic. The electrical connection of the solar cells 14 into series connections and string terminations is important customization for the end customer and is done independent of the layout. The front contacts 32 and back contacts 34 in the corner regions 26 of the solar cells 14 must be connected. This can be done in many combinations in order to route current through a desired path.

Connections are made between the solar cells 14 and the corner conductors 20. Front and back contacts 32, 34 of the solar cells 14 are present in each corner region 26 for attachment to the corner conductors 20. Interconnects for the front and back contacts 32, 34 of each of the solar cells 14 are welded, soldered, or otherwise bonded onto the corner conductors 20 to provide a conductive path 20, 32, 34 for routing current out of the solar cells 14.

Using the corner conductors 20, any customization can be made in the electrical connections. Adjacent solar cells 14 can be electrically connected to flow current in up/down or left/right directions as desired by the specific design. Current flow can also be routed around stay-out zones as needed. The length or width of the solar cell array 22 can be set as desired. Also, the width can vary over the length of the array 22.

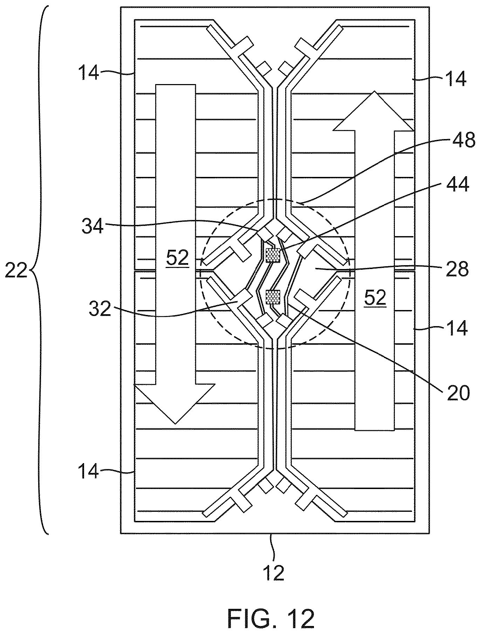

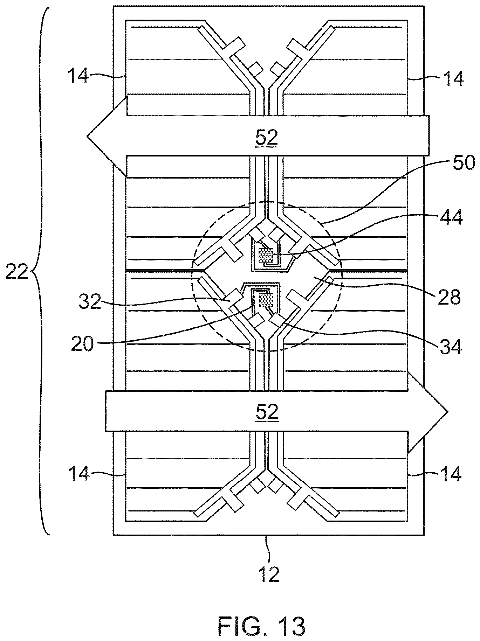

In one example, the electrical connections are series connections that determine a flow of current through the plurality of solar cells 14. This may be accomplished by the connection schemes shown in FIGS. 12 and 13, wherein FIG. 12 shows up/down series connections 48 between the solar cells 14 of the array 22, and FIG. 13 shows left/right series connections 50 between the solar cells 14 of the array 22. In both FIGS. 12 and 13, these series connections 48, 50 are electrical connections between the front contacts 32 and back contacts 34 of the solar cells 14, and the bypass diodes 44, are made using the corner conductors 20 formed on or in the exposed areas 28 of the substrate 12. These series connections 48, 50 determine the current (power) flow, as indicated by the arrows 52, through the solar cells 14.

The corner conductors 20 between solar cells 14 can be in many forms. They could be accomplished using wires that have electrical connections made on both ends, which could be from soldering, welding, conducting adhesive, or other process. In addition to wires, metal foil connectors, similar to the interconnects could be applied. Metal conductive paths or traces (not shown) can also be integrated with the substrate 12.

In summary, this new approach attaches the solar cells 14 individually to a substrate 12 such that the corner regions 26 of two, three or four adjacent solar cells 14 are aligned on the substrate 12. The solar cells 14 can be laid out so that the cropped corners 24 are aligned and the corner regions 26 are adjacent, thereby exposing an area 28 of the substrate 12. Electrical connections between solar cells 14 are made in these corner regions 26 between front contacts 32 and back contacts 34 on the solar cells 14, bypass diodes 44, and comer conductors 20 on or in the exposed area 28 of the substrate 12, wherein these conductive paths are used to create a string of solar cells 14 in a series connection 48, 50 comprising a circuit.

### REWORK AND REPAIR OF COMPONENTS

While the use of electrical connections between solar cells 14 in these corner regions 26 facilitates automation, there are limits to the rework and repair capabilities of this design. Solar cell arrays 22 go through much activity before deployment, and there are numerous chances for defects both in early manufacture and during later assembly stages, however rare. It is necessary to have a path for rework and repair to replace damaged materials.

Specifically, a rework and repair process is necessary for the 2D grid of the array 22, and it is not clear how that is achieved using existing techniques. For example, the extraction and replacement of components may result in a second electrical interconnect made in the same location as a first electrical interconnect, and such a repeated connection may not have sufficient strength.

This disclosure describes a connector design that simplifies rework of these items, and facilitates repairs of the solar cell array 22. Specifically, an electrical connection is repaired by removing a first interconnect in a first location in the electrical connection and by forming a second interconnect in a second location in the electrical connection different from the first location. The second location may be adjacent the first location. An area of the corner conductor used for the electrical connection is large enough to encompass both the first and second locations and preferably allows electrical current to flow around the first location.

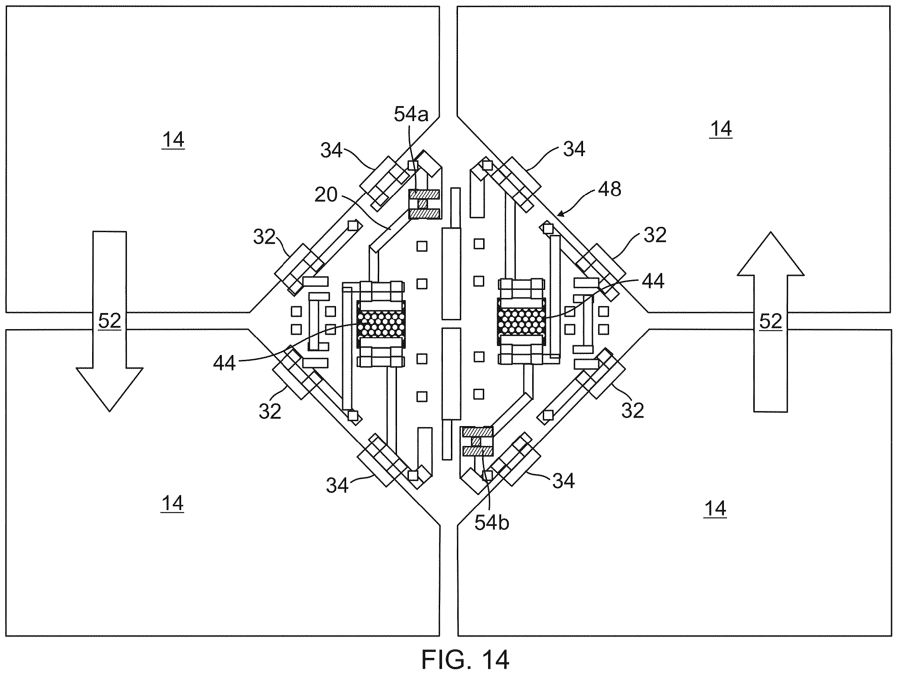

FIG. 14 further illustrates a connection scheme between a plurality of solar cells 14, according to one example. The connection scheme shown comprises up/down series connections 48 between the front contacts 32 and back contacts 34 of the solar cells 14, and the bypass diodes 44, made in the exposed areas 28 of the substrate 12, using the corner conductors 20. These series connections 48 determine the flow of current, as indicated by the arrows 52, through the solar cells 14.

One or more conductor elements may be added to or removed from the corner region 26 to select current pathways for the solar cells 14. In one example, the conductor element comprises a jumper 54a, 54b that allows circuits to be terminated at the corner regions 26 or to direct current to the next solar cell 14. The jumpers 54a, 54b bridge the electrical connections from at least one of the corner conductors 20 to one or more other conductive paths.

Each jumper 54a, 54b is a metal foil interconnect that is similar to existing metal interconnects used in solar cell panels 10. In one example, each jumper 54a, 54b has a shape comprised of two flange elements with parallel planes connected by a web element, which enables multiple connection points. The jumper 22 could be welded, soldered, or joined by other methods, onto the conducting paths and connection pads. Other types of conductive elements, such as wires, as well as other shapes, could also be employed.

Specifically, FIG. 14 shows a jumper 54a that connects the back contact 34 of the top left solar cell 14 to the front contact 32 of the bottom left solar cell 14. This jumper 54a also connects through the bypass diode 44 to the back contact 34 of the bottom left solar cell 14. This connection path provides for the current flow 52 from top to bottom shown on the left side of the figure. A similar configuration using jumper 54b provides for the current flow 52 from bottom to top shown on the right side of the figure.

The value of this structure is significant. Now, there is a single printed corner conductor 20 pattern, single layout of solar cells 14, and single layout of bypass diodes 44. This single configuration has great advantages for automation of manufacturing, testing, and inspection. The application of a jumper 54a, 54b provides for a simple way to control the number of solar cells 14 in a circuit.

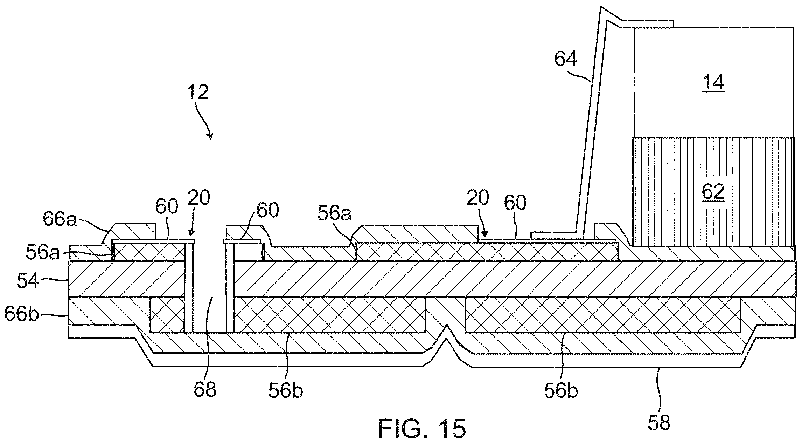

FIG. 15 shows a side view of an example wherein the substrate 12 is a flex sheet assembly, according to one example. The substrate 12 includes a polyimide base layer 54 with Copper (Cu) layer 56a above and Cu layer 56b below, wherein Cu layers 56a and 56b form a multilayer conductor. A conducting back sheet of polyimide 58 can be applied to the substrate 12, which is useful in a space environment in that it will reduce the accumulation of charge. Another capability is the addition of a plated Silver (Ag) or Gold (Au) layer 60 on the Cu layer 56a, which improves the ability to make connections. The Cu layer 56a with plated Ag or Au layer 60 is patterned as the corner conductors 20, and the Cu layer 56b is patterned to form buried conductors within the substrate 12, including, for example, power and common lines.

Shown on the right side is the solar cell 14 that is attached to the substrate 12 with adhesive 62. Also visible is the metal foil interconnect 64 attached to the solar cell 14 and the plated Ag or Au layer 60 of the corner conductors 20. This is a rather typical construction and assembly that could form the structures presented in earlier figures.

The substrate 12 also includes insulating layers that separate at least one of the multilayer conductors 56a, 56b from at least another one of the multilayer conductors 56a, 56b. In one example, there are a top polyimide overlay layer 66a and bottom polyimide overlay layer 66b, wherein the top polyimide overlay layer 66a has one or more holes drilled through it, and the holes are Cu-plated vias 68 that electrically connect Cu layer 56a with Cu layer 56b.

Polyimide has a high breakdown strength, greater than air or vacuum, and the polyimide overlay layers 66a, 66b are useful for preventing electrostatic discharge (ESD), which is an important concern in the space environment. Furthermore, this enables corner conductors 20 to pass under the solar cell 14. The adhesive 62 is non-conducting, but the continuous polyimide layer of the polyimide overlay layers 66a, 66b offers significant protection against shorting between buried conductors in Cu layers 56a, 56b and the solar cell 14.

In another example, the top polyimide overlay layer 66a may be omitted underneath the solar cell 14. This may be advantageous if the top polyimide overlay layer 66a is prone to bubbles or other defects.

In another example, there is an alignment between Cu layer 56a, Cu layer 56b and the top polyimide overlay layer 66a. In this example, the top polyimide overlay layer 66a almost fully encases the Cu layer 56a, polyimide layer 54, and Cu layer 56b, with only small access holes to the Cu layer 56a and Cu layer 56b. This requires the top polyimide overlay layer 66a to roll up and over the corners of the Cu layers 56a and 56b. By encasing the metal of the Cu layers 56a, 56b, the top polyimide overlay layer 66a provides valuable protection against ESD.

In another example, the top polyimide overlay layer 66a has larger holes to avoid overlapping the edges of the Cu layers 56a and 56b. This top polyimide overlay layer 66a may be easier to fabricate with less defects than a full top polyimide overlay layer 66a.

In another example, there is a connection between two or more traces of the Cu layer 56a, wherein the traces of the Cu layer 56a are also connected by vias 68 to Cu layer 56b. The top polyimide overlay layer 66a may not be needed; in that case, there would be no hindrance of the top polyimide overlay layer 66a to any jumper 54 connection.

In another example, a jumper 54 (not shown) may connect directly from the Cu layer 56a to the Cu layer 56b. This eliminates the Cu-plated via 68 connections, which could be a reliability concern, especially in the flex sheet assembly. However, there is more polyimide topography from the top polyimide overlay layer 66a that the jumper 54 needs to reach over. The thickness of the top polyimide overlay layer 66a is typically about ~0.1 mm, while the length of the jumper 54 typically may be about ~4 mm. Having the metal of the jumper 54 surrounded by large amounts of polyimide from the top polyimide overlay layer 66a may impede the jumper 54, but will also impede ESD, which can be valuable.

In another example, electrical access is provided to the buried Cu layer 56b. This could be accomplished with the via 68 connection between Cu layer 56a and Cu layer 56b, or with a direct connection between Cu layer 56a and Cu layer 56b. Also, there may be multiple connections between Cu layer 56a and Cu layer 56b. This redundancy is an important attribute and can be employed when possible.

In another example, the traces of the Cu layers 56a, 56b can be broadened into wider conductors, power lines and common lines that do not have the insulating polyimide layers 66a, 66b between them. Thus, there is more Copper used for conduction, which reduces resistance losses. This does reduce the number of discrete conductors; however, the connection redundancy is preserved.

If there is a problem with the solar cell 14 or its connections, they may need to be replaced. Mechanical removal of the solar cell 14 and the adhesive 62 attaching it to the surface of the flex sheet substrate 12 is a known process. This disclosure, on the other hand, is focused on reworking or repairing the electrical connections.

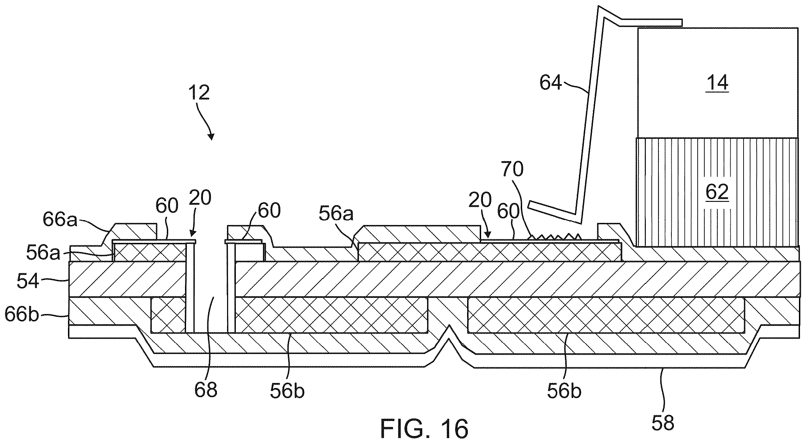

FIG. 16 illustrates an example where the metal foil interconnect 64 from the solar cell 14 has separated from the plated Ag or Au layer 60 and/or Cu layer 56a. This separation may be the defect causing the rework process. Alternatively, there could be another defect causing this connection to be purposely separated. For example, a cracked solar cell 14 would need to be removed including the interconnections to the substrate 12. The separation results in a change in the surface region of the plated Ag or Au layer 60 and/or Cu layer 56a, for example, resulting in some debris 70, such as solder residue, roughness, etc.

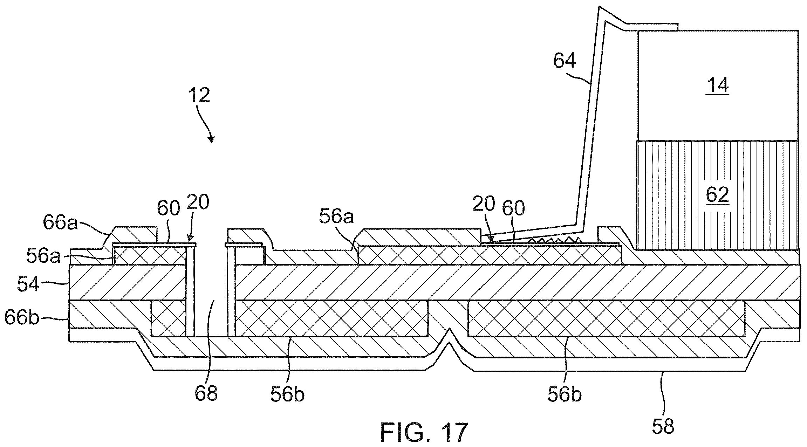

FIG. 17 shows one proposed process for repairing the substrate 12 in the example of FIG. 16, wherein an area of the plated Ag or Au layer 60 and/or Cu layer 56a used for the electrical connection is large enough that one or more additional connections can be made in the area. In this example, the replacement solar cell 14 is attached to the flex sheet substrate 12 using adhesive 62, and the replacement interconnect 64 extends from the replacement solar cell 14 to make contact with the plated Ag or Au layer 60 and/or Cu layer 56a in an adjacent location that avoids the original connection region. The adjacent location in this example has enough conductor for electrical current to flow around the damaged region.

There could be an inventory of CICs with different length interconnects for first assembly, first rework, second rework, etc. Alternatively, a single CIC could be built with an interconnect having a length available for initial assembly and all anticipated rework processes.

Specifically, an electrical connection is repaired by removing a first interconnect 64 in a first location in the electrical connection and by forming a second interconnect 64 in a second location in the electrical connection different from the first location. The second location may be adjacent the first location, for example, when the plated Ag or Au layer 60 and/or Cu layer 56a comprise a connection pad that is large enough to encompass both the first and second locations and to allow electrical current to flow around the first location. In one example, the first interconnect 64 in the first location is completely removed, while in another example, a joint remains when the first interconnect 64 is removed.

In another proposed repair process, similar to that shown in FIG. 17, the area of the plated Ag or Au layer 60 and/or Cu layer 56a has been ruptured or divoted. Like FIG. 17, a replacement solar cell 14 is attached to the flex sheet substrate 12 using adhesive 62, and a replacement interconnect 64 extends from the replacement solar cell 14 to make contact with the plated Ag or Au layer 60 and/or Cu layer 56a in an adjacent location that avoids the original connection region, wherein the adjacent location has enough conductor for electrical current to flow around the damaged region.

In another proposed repair process, wherein the original interconnect 64 to the solar cell 14 is cut, but a joint of the interconnect 64 remains intact and bonded to the plated Ag or Au layer 60 and/or Cu layer 56a, a replacement interconnect 64 is attached to the plated Ag or Au layer 60 and/or Cu layer 56a in an adjacent location that avoids the original connection region, wherein the adjacent location has enough conductor for electrical current to flow around the joint of the interconnect 64. Maintaining the joint of the interconnect 64 may be preferred as this avoids damage to the plated Ag or Au layer 60 and/or Cu layer 56a, for example, by rupturing or divoting.

Different types of repair components may be used, based on two types of interconnects. A first type of repair components could be used in connecting a solar cell 14 or bypass diode 44 to the substrate 12, while a second type of repair components could be used to connect pairs of corner conductors 20 on the substrate 12. The first type of repair components would be the standard interconnects 64, while the second type of repair components would be variations of the standard interconnects 64 used for the repair process, i.e., replacement interconnects 64, which have a slightly different structure that moves the electrical connection to an adjacent location from the original connection. It is desirable to position the initial and rework connection points, such that debris 70, cut interconnect 64, or rupturing or divoting of the plated Ag or Au layer 60 and/or Cu layer 56a, does not impact repair assembly or current flow.

Another variation is where the type of repair components is designed to allow initial and rework connections to be made using the same interconnect 64 structure. Thus, a single interconnect 64 is needed. This interconnect 64 is used for both the initial build and for rework. There would be initial and rework pairs of connection points on the plated Ag or Au layer 60 and/or Cu layer 56a for the initial and rework connections. Again, it is desirable to design these parts and the conducting path on the substrate 12, such that rupture of the conducting path on the substrate 12 does not impact conductivity after rework.

In the case where a connection point is inadequate, this interconnect design enables an additional connection point to be used. The interconnect 64 can be left in place and an adjacent location of the plated Ag or Au layer 60 and/or Cu layer 56a can be used to provide greater reliability. This avoids the possibility of further damage during the rework process.

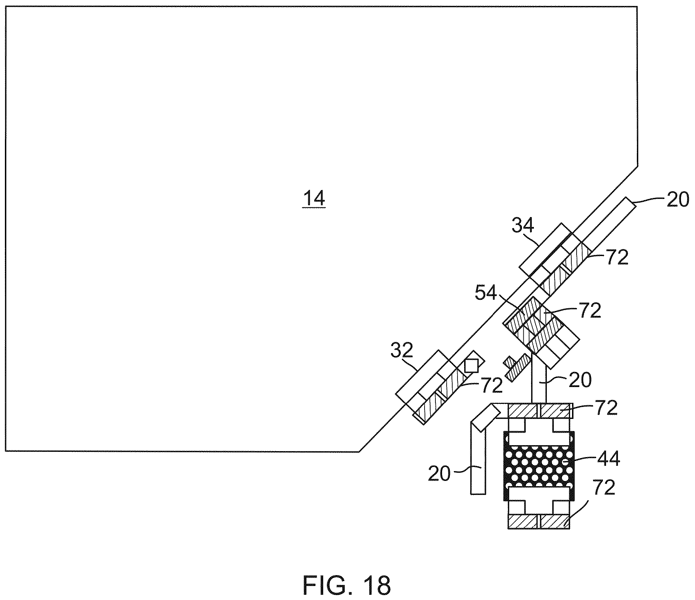

FIG. 18 shows how repair components 72 are used, according to one example. In this example, the repair components 72 comprise replacement interconnects 64 connecting the front or back contacts 32, 34 to the corner conductors 20, or replacement interconnects 64 connecting the bypass diodes 44 to the corner conductors 20, or jumpers 54 connecting the corner conductors 20. Generally, the following steps are performed: separate interconnects 64 at a weld joint, clean out the solar cell 14 and/or bypass diode 44, replace the solar cell 14 and/or bypass diode 44 with a repair unit, and weld the interconnects 64 at adjacent locations to the corner conductors 20 or front and back contacts 32, 34, or connect a jumper 54 between corner conductors 20, wherein all work is performed on a top side of the assembly with no components sticking up.

Preferably, all the electrical connections in this assembly are made by overlapping metal layers. Then, a joint is formed by access from the top for solder or weld processes (laser, resistive, ultrasonic, etc.). This access is very straightforward, as there is no overlapping or folding of conductors. Also, the repair has no material sticking up higher than the original assembly, which is a concern for space solar panels 10a that are often folded tightly for stowage and launch.

### FABRICATION

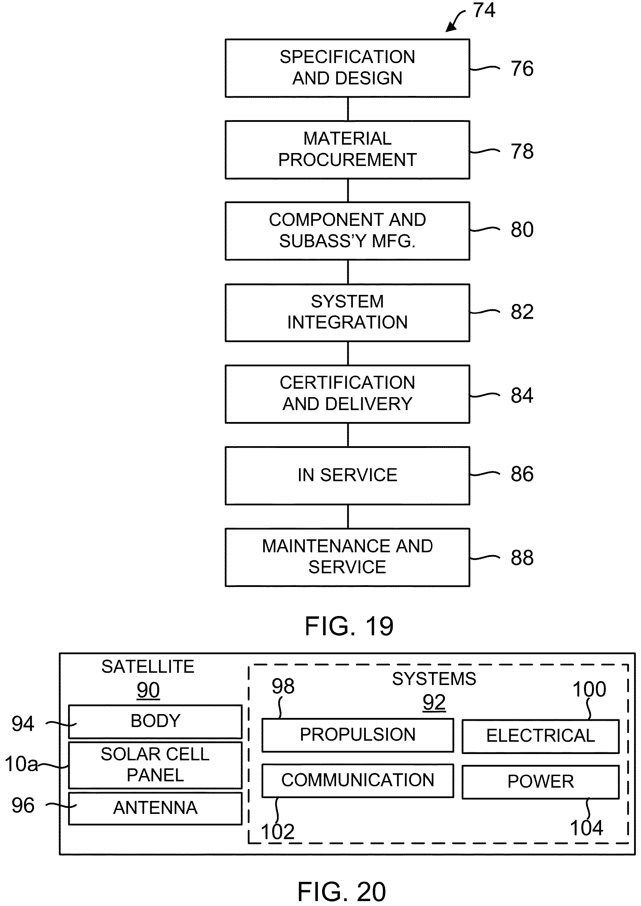

Examples of the disclosure may be described in the context of a method 74 of fabricating a solar cell 14, solar cell panel 10a and/or satellite, comprising steps 76-88, as shown in FIG. 19, wherein the resulting satellite 90 having a solar cell panel 10a comprised of solar cells 14 are shown in FIG. 20.

As illustrated in FIG. 19, during pre-production, exemplary method 74 may include specification and design 76 of the solar cell 14, solar cell panel 10a and/or satellite 90, and material procurement 78 for same. During production, component and subassembly manufacturing 80 and system integration 82 of the solar cell 14, solar cell panel 10a and/or satellite 90 takes place, which include fabricating the solar cell 14, solar cell panel 10a and/or satellite 90. Thereafter, the solar cell 14, solar cell panel 10a and/or satellite 90 may go through certification and delivery 84 in order to be placed in service 86. The solar cell 14, solar cell panel 10a and/or satellite 90 may also be scheduled for maintenance and service 88 (which includes modification, reconfiguration, refurbishment, and so on), before being launched.

Each of the processes of method 74 may be performed or carried out by a system integrator, a third party, and/or an operator (e.g., a customer). For the purposes of this description, a system integrator may include without limitation any number of solar cell, solar cell panel, satellite or spacecraft manufacturers and major-system subcontractors; a third party may include without limitation any number of venders, subcontractors, and suppliers; and an operator may be a satellite company, military entity, service organization, and so on.

As shown in FIG. 20, a satellite 90 fabricated by exemplary method 74 may include systems 92, a body 94, solar cell panels 10a comprised of solar cells 14, and one or more antennae 96. Examples of the systems 92 included with the satellite 90 include, but are not limited to, one or more of a propulsion system 98, an electrical system 100, a communications system 102, and a power system 104. Any number of other systems 92 also may be included.

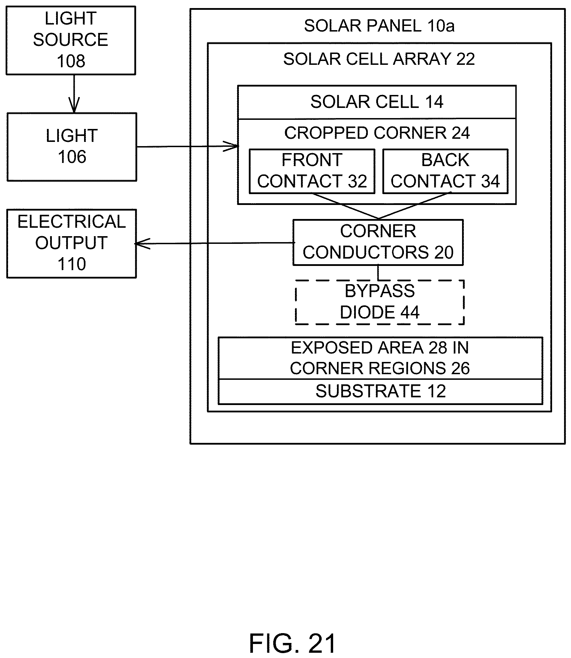

FIG. 21 is an illustration of the solar cell panel 10a in the form of a functional block diagram, according to one example. The solar cell panel 10a is comprised of the solar cell array 22, which is comprised of one or more of the solar cells 14 individually attached to the substrate 12. Each of the solar cells 14 absorbs light 106 from a light source 108 and generates an electrical output 110 in response thereto.

At least one of the solar cells 14 has at least one cropped corner 24 that defines a corner region 26, such that an area 28 of the substrate 12 remains exposed when the solar cell 14 is attached to the substrate 12. When a plurality of solar cells 14 are attached to the substrate 12, the corner regions 26 of adjacent ones of the solar cells 14 are aligned, thereby exposing the area 28 of the substrate 12.

The area 28 of the substrate 12 that remains exposed includes one or more corner conductors 20 attached to, printed on, or integrated with the substrate 12, and one or more electrical connections between the solar cells 14 and the corner conductors 20 are made in a corner region 26 resulting from the cropped corner 24 of the at least one of the solar cells 14.

The corner region 26 resulting from the cropped corner 24 includes at least one contact, for example, a front contact 32 on a front side of the solar cell 14 and/or a back contact 34 on a back side of the solar cell 14, for making the electrical connections between the corner conductors 20 and the solar cell 14. The electrical connections may comprise up/down or left/right series connections that determine a flow of power through the solar cells 14, and may include one or more bypass diodes 44.

The description of the examples set forth above has been presented for purposes of illustration and description, and is not intended to be exhaustive or limited to the examples described.

## Claims

1. A substrate (12) for solar cells (14), wherein the substrate (12) is configured such that:
an area (28) of the substrate (12) remains exposed when at least one solar cell (14) having at least one cropped corner (24) that defines a corner region (26) is attached to the substrate (12), wherein the area (28) of the substrate (12) that remains exposed includes a corner conductor (20);
an electrical connection between one of the solar cells (14) and the corner conductor (20) can be made in the corner region (26); and
the electrical connection, which is establishable by connecting a first interconnect (64) in a first location of the corner conductor (20) to the one of the solar cells (14), is repairable by connecting a second interconnect in a second location of the corner conductor (20) different from the first location, and
wherein an area of the corner conductor (20) used for the electrical connection is large enough to encompass both the first and second locations.

2. The substrate of claim 1, wherein the area of the corner conductor used for the electrical connection is large enough for electrical current to flow around the first location.

3. The substrate of claim 1 or 2, wherein a joint remains when the first interconnect (64) is removed.

4. The substrate of any one of claims 1-3, wherein the second location is adjacent the first location.

5. The substrate of any one of claims 1-4, wherein the electrical connection is repairable by replacing the first interconnect with an other interconnect and connecting the other interconnect in an other location of the corner conductor (20) different from the first location.

6. A method for repairing a substrate (12) on which solar cells (14) are attached, wherein the substrate (12) is configured such that:
an area (28) of the substrate (12) remains exposed when at least one solar cell (14) having at least one cropped corner (24) that defines a corner region (26) is attached to the substrate (12), wherein the area (28) of the substrate (12) that remains exposed includes a corner conductor (20);
an electrical connection between one of the solar cells (14) and the corner conductor (20) is made in the corner region (26); and
the electrical connection is establishable by connecting a first interconnect (64) in a first location of the corner conductor (20) to the one of the solar cells (14),
the method comprising the step of:
repairing the electrical connection by connecting a second interconnect in a second location of the corner conductor (20) different from the first location, wherein an area of the corner conductor used for the electrical connection is large enough to encompass both the first and second locations.

7. The method of claim 6, wherein the area of the corner conductor used for the electrical connection is large enough for electrical current to flow around the first location.

8. The method of any one of claims 6-7, wherein the first interconnect (64) in the first location is removed.

9. The method of claim 8, wherein a joint remains when the first interconnect is removed.

10. The method of any one of claims 6-9, the second location is adjacent the first location.

11. The method of any one of claims 6-10, wherein the electrical connection is repaired by replacing the first interconnect with an other interconnect and connecting the other interconnect in an other location of the corner conductor (20) different from the first location.

12. A solar cell panel, comprising:
a solar cell (14) array (22) comprised of at least one solar cell (14) having at least one cropped corner (24) that defines a corner region (26) and a substrate (12) according to claim 1.

13. The solar cell panel of claim 12, wherein the area of the corner conductor used for the electrical connection is large enough for electrical current to flow around the first location.

14. The solar cell panel of any one of claims 12-13, wherein a joint remains when the first interconnect (64) is removed.

15. The solar cell panel of any one of claims 12-14, wherein the at least one of the electrical connections is repairable by replacing the first interconnect with an other interconnect and connecting the other interconnect in an other location of the corner conductor (20) different from the first location.

## Patentansprüche

1. Substrat (12) für Solarzellen (14), wobei das Substrat (12) derart eingerichtet ist, dass:
eine Fläche (28) des Substrats (12) frei bleibt, wenn zumindest eine Solarzelle (14) mit zumindest einer gestutzten Ecke (24), die einen Eckbereich (26) definiert, an dem Substrat (12) angebracht ist, wobei die Fläche (28) des Substrats (12), die frei bleibt, einen Eckleiter (20) umfasst;
eine elektrische Verbindung zwischen einer der Solarzellen (14) und dem Eckleiter (20) in dem Eckbereich (26) hergestellt werden kann; und
die elektrische Verbindung, die errichtet werden kann, indem ein erstes Verbindungsstück (64) an einem ersten Ort des Eckleiters (20) mit der einen der Solarzellen (14) verbunden wird, reparierbar ist, indem ein zweites Verbindungsstück an einem zweiten Ort des Eckleiters (20), der sich von dem ersten Ort unterscheidet, verbunden wird, und
wobei eine Fläche des Eckleiters (20), die für die elektrische Verbindung verwendet wird, groß genug ist, um sowohl den ersten Ort als auch den zweiten Ort zu umfassen.

2. Substrat nach Anspruch 1, wobei die Fläche des Eckleiters, die für die elektrische Verbindung verwendet wird, groß genug ist, dass ein elektrischer Strom um den ersten Ort herum fließt.

3. Substrat nach Anspruch 1 oder 2, wobei eine Verbindung bleibt, wenn das erste Verbindungsstück (64) entfernt wird.

4. Substrat nach einem der Ansprüche 1-3, wobei der zweite Ort benachbart zum ersten Ort liegt.

5. Substrat nach einem der Ansprüche 1-4, wobei die elektrische Verbindung reparierbar ist, indem das erste Verbindungsstück durch ein anderes Verbindungsstück ersetzt wird und indem das andere Verbindungsstück an einem anderen Ort des Eckleiters (20) verbunden wird, der sich von dem ersten Ort unterscheidet.

6. Verfahren zum Reparieren eines Substrats (12), auf dem Solarzellen (14) angebracht sind, wobei das Substrat (12) derart eingerichtet ist, dass:
eine Fläche (28) des Substrats (12) frei bleibt, wenn zumindest eine Solarzelle (14) mit zumindest einer gestutzten Ecke (24), die einen Eckbereich (26) definiert, an dem Substrat (12) angebracht ist, wobei die Fläche (28) des Substrats (12), die frei bleibt, einen Eckleiter (20) umfasst;
eine elektrische Verbindung zwischen einer der Solarzellen (14) und dem Eckleiter (20) in dem Eckbereich (26) hergestellt wird; und
eine elektrische Verbindung vorgesehen ist, die errichtet werden kann, indem ein erstes Verbindungsstück (64) an einem ersten Ort des Eckleiters (20) mit der einen der Solarzellen (14) verbunden wird,
wobei das Verfahren die Schritte aufweist:
Reparieren der elektrischen Verbindung durch Verbinden eines zweiten Verbindungsstücks an einem zweiten Ort des Eckleiters (20), der sich von dem ersten Ort unterscheidet, wobei eine Fläche des Eckleiters, die für die elektrische Verbindung verwendet wird, groß genug ist, um sowohl den ersten Ort als auch den zweiten Ort zu umgeben.

7. Verfahren nach Anspruch 6, wobei die Fläche des Eckleiters, die für die elektrische Verbindung verwendet wird, ausreichend groß ist, dass ein elektrischer Strom um den ersten Ort herum fließt.

8. Verfahren nach einem der Ansprüche 6-7, wobei das erste Verbindungsstück (64) am ersten Ort entfernt ist.

9. Verfahren nach Anspruch 8, wobei eine Verbindung bleibt, wenn das erste Verbindungsstück entfernt ist.

10. Verfahren nach einem der Ansprüche 6-9, wobei der zweite Ort benachbart zum ersten Ort liegt.

11. Verfahren nach einem der Ansprüche 6-10, wobei die elektrische Verbindung repariert wird, indem das erste Verbindungsstück mit einem anderen Verbindungsstück ersetzt wird und indem das andere Verbindungsstück an einem anderen Ort des Eckleiters (20) verbunden wird, der sich vom ersten Ort unterscheidet.

12. Solarzellenpanel, das aufweist:
eine Solarzellen-Anordnung (22), die zumindest eine Solarzelle (14) mit einer gestutzten Ecke (24), die einen Eckbereich (26) definiert, und ein Substrat (12) gemäß Anspruch 1 aufweist.

13. Solarzellenpanel nach Anspruch 12, wobei die Fläche des Eckleiters, die für die elektrische Verbindung verwendet wird, groß genug ist, dass ein elektrischer Strom um den ersten Ort herum fließt.

14. Solarzellenpanel nach einem der Ansprüche 12-13, wobei eine Verbindung bleibt, wenn das erste Verbindungsstück (64) entfernt ist.

15. Solarzellenpanel nach einem der Ansprüche 12-14, wobei die zumindest eine der elektrischen Verbindungen reparierbar ist, indem das erste Verbindungsstück mit einem anderen Verbindungsstück ersetzt wird und indem das andere Verbindungsstück an einem anderen Ort des Eckleiters (20) verbunden wird, der sich von dem ersten Ort unterscheidet.

## Revendications

1. Substrat (12) pour des cellules solaires (14), le substrat (12) étant configuré de telle sorte que :
une zone (28) du substrat (12) reste exposée lorsqu'au moins une cellule solaire (14) ayant au moins un coin tronqué (24) qui définit une région de coin (26) est fixée au substrat (12), la zone (28) du substrat (12) qui reste exposée comportant un conducteur de coin (20) ;
une connexion électrique entre une des cellules solaires (14) et le conducteur de coin (20) peut être réalisée dans la région de coin (26) ; et
la connexion électrique, qui peut être établie en connectant une première interconnexion (64) à un premier emplacement du conducteur de coin (20) à ladite une des cellules solaires (14), est réparable en connectant une deuxième interconnexion à un deuxième emplacement du conducteur de coin (20) différent du premier emplacement, et
une zone du conducteur de coin (20) utilisée pour la connexion électrique étant suffisamment large pour englober à la fois les premier et deuxième emplacements.

2. Substrat selon la revendication 1, la zone du conducteur de coin utilisée pour la connexion électrique étant suffisamment large pour qu'un courant électrique circule autour du premier emplacement.

3. Substrat selon la revendication 1 ou 2, un joint restant lorsque la première interconnexion (64) est retirée.

4. Substrat selon l'une quelconque des revendications 1 à 3, le deuxième emplacement étant adjacent au premier emplacement.

5. Substrat selon l'une quelconque de revendications 1 à 4, la connexion électrique étant réparable en remplaçant la première interconnexion avec une autre interconnexion et en connectant l'autre interconnexion à un autre emplacement du conducteur de coin (20) différent du premier emplacement.

6. Procédé de réparation d'un substrat (12) sur lequel des cellules solaires (14) sont fixées, le substrat (12) étant configuré de telle sorte que :
une zone (28) du substrat (12) reste exposée lorsqu'au moins une cellule solaire (14) ayant au moins un coin tronqué (24) qui définit une région de coin (26) est fixée au substrat (12), la zone (28) du substrat (12) qui reste exposée comportant un conducteur de coin (20) ;
une connexion électrique entre une des cellules solaires (14) et le conducteur de coin (20) est réalisée dans la région de coin (26) ; et
la connexion électrique établie en connectant une première interconnexion (64) à un premier emplacement du conducteur de coin (20) à ladite une des cellules solaires (14),
le procédé comprenant l'étape de :
réparation de la connexion électrique en connectant une deuxième interconnexion à un deuxième emplacement du conducteur de coin (20) différent du premier emplacement, une zone du conducteur de coin utilisée pour la connexion électrique étant suffisamment large pour englober à la fois les premier et deuxième emplacements.

7. Procédé selon la revendication 6, la zone du conducteur de coin utilisée pour la connexion électrique étant suffisamment large pour qu'un courant électrique circule autour du premier emplacement.

8. Procédé selon l'une quelconque des revendications 6 et 7, la première interconnexion (64) au premier emplacement étant retirée.

9. Procédé selon la revendication 8, un joint restant lorsque la première interconnexion est retirée.

10. Procédé selon l'une quelconque des revendications 6 à 9, le deuxième emplacement étant adjacent au premier emplacement.

11. Procédé selon l'une quelconque des revendications 6 à 10, la connexion électrique étant réparable en remplaçant la première interconnexion avec une autre interconnexion et en connectant l'autre interconnexion à un autre emplacement du conducteur de coin (20) différent du premier emplacement.

12. Panneau à cellules solaires, comprenant :
une matrice (22) de cellules solaires (14) comprenant au moins une cellule solaire (14) ayant au moins un coin tronqué (24) qui définit une région de coin (26) et un substrat (12) selon la revendication 1.

13. Panneau à cellules solaires selon la revendication 12, la zone du conducteur de coin utilisée pour la connexion électrique étant suffisamment large pour qu'un courant électrique circule autour du premier emplacement.

14. Panneau à cellules solaires selon l'une quelconque des revendications 12 et 13, un joint restant lorsque la première interconnexion (64) est retirée.

15. Panneau à cellules solaires selon l'une quelconque des revendications 12 à 14, l'au moins une des connexions électriques étant réparable en remplaçant la première interconnexion avec une autre interconnexion et en connectant l'autre interconnexion à un autre emplacement du conducteur de coin (20) différent du premier emplacement.
